# EUROPÄISCHE PATENTANMELDUNG

(11) **EP 1 785 456 A2**
(43) Veröffentlichungstag der Anmeldung: **16.05.2007**
(21) Anmeldenummer: 06023554.6
(22) Anmeldetag: 13.11.2006
(51) Int. Cl.: C09D 5/00, C09D 101/10, C09D 101/16, H05K 3/28

(54) **Schutzlacke für den klimatischen Schutz von elektrischen und/oder elektronischen Baugruppen und/oder Bauelemente auf Basis nachwachsender Rohstoffe**

(30) Priorität: 14.11.2005 DE 102005054561
(71) Anmelder: Peters Research GmbH + Co. KG, 47906 Kempen (DE)
(72) Erfinder: Peters, Werner, 47906 Kempen (DE); Dietrich, Rüdiger, 47906 Kempen (DE); Suppa, Manfred, Dr., 44803 Bochum (DE); Kall, Dirk, 41334 Nettetal (DE)
(74) Vertreter: Bergmann, Michael

(57) **Zusammenfassung**

Für eine Schutzlackformulierung, die als Klima- und/oder Feuchteschutzüberzug auf elektrische und/oder elektronische Baugruppen oder Bauelemente aufbringbar ist, soll eine Lösung geschaffen werden, mit der ein Ressourcen schonender Klima- und Feuchteschutz für elektrische und/oder elektronische Bauelemente und/oder Baugruppen herstellbar ist. Dies wird dadurch erreicht, dass die Schutzlackformulierung zumindest im Wesentlichen auf zumindest einer aus mindestens einem nachwachsenden Rohstoff erhaltenen Komponente basiert und mindestens einen aus mindestens einem nachwachsenden Rohstoff erhaltenen Celluloseester oder mindestens einen aus mindestens einem nachwachsenden Rohstoff erhaltenen Cyclokautschuk umfasst.

## Beschreibung

Die Erfindung richtet sich auf eine Schutzlackformulierung, die als Klima- und/oder Feuchteschutzüberzug auf elektrische und/oder elektronische Baugruppen und/oder Bauelemente aufbringbar ist. Sie betrifft weiterhin die Verwendung dieser Schutzlackformulierung und richtet sich darüber hinaus auf eine Feuchteschutzbeschichtung eines elektrischen oder elektronischen Bauelementes oder einer elektrischen oder elektronischen Baugruppe. Schließlich richtet sich die Erfindung auch auf ein(e) elektrische(s) und/oder elektronische(s) Baugruppe oder Bauelement, die/das ganz oder teilweise einen Klima- und/oder Feuchteschutzüberzug aus einem Schutzlack aufweist.

Üblicherweise werden Schutzlacke zur Ausbildung von Klima- und Feuchteschutzüberzügen von elektronischen Baugruppen oder Bauelementen mit chemisch synthetisierten und erdölstämmigen Harzen auf Basis von Polyacrylaten und Polyestern (Alkydharze) bzw. modifizierten Polyestern oder auch Silikonen hergestellt. Die Silikone sind zwar von ihrer Grundchemie her nicht erdölstämmig, sind aber auf Grund ihrer erforderlichen Syntheseschritte als reine Syntheseprodukte zu betrachten.

Unter der dringlichen Forderung nach ressourcenschonenden Produkten für die elektronische Industrie (EuP Richtlinie zur Umweltgerechten Gestaltung energiebetriebener Produkte, Energy using Products (EuP); RICHTLINIE 2005/32/EG DES EUROPÄISCHEN PARLAMENTS UND DES RATES vom 6. Juli 2005) bekommen ressourcenschonende oder nachwachsende Rohstoffe ein größeres Gewicht. Unter "nachwachsende Rohstoffe" sind hier Stoffe zu verstehen, die aus lebender Materie stammen und vom Menschen zielgerichtet für Zwecke außerhalb des Nahrungs- und Futterbereiches verwendet werden.

Eine Lackformulierung muss eine Reihe von Eigenschaften aufweisen, um für die Verwendung als Schutzlack für den Klima- und/oder Feuchteschutz von elektrischen und/oder elektronischen Baugruppen und/oder Bauelementen geeignet zu sein. Zu diesen Merkmalen zählen eine geeignete Viskosität, eine hohe Temperaturwechselfestigkeit, ein hoher elektrischer Widerstand und eine hohe chemische Widerstandsfähigkeit, insbesondere unter Feuchtebelastungen, wie hohe Luftfeuchten und/oder Betauung. Elektrische und/oder elektronische Baugruppen und/oder Bauelemente schließen beispielsweise Leiterplatten ein, insbesondere solche, die unter Feuchtebelastungen, wie hohe Luftfeuchten und/oder Betauung eingesetzt werden.

Bekannte Lackformulierungen auf Basis nachwachsender Rohstoffe haben die Nachteile einer großen Härte und Sprödigkeit und sind daher für die Anwendung als Schutzlack für elektrische und/oder elektronische Baugruppen und/oder Bauelemente nicht geeignet. Ferner werden die Eigenschaften einer Lackformulierung auf Basis nachwachsender Rohstoffe durch die Quelle des Rohstoffs und dessen natürliche Eigenschaften beschränkt. Im Gegensatz zu synthetischen Lackformulierungen, haben solche Lackformulierungen, die auf natürlichen Rohstoffen basieren, daher den Nachteil in ihren Eigenschaften nur sehr beschränkt variierbar zu sein. Diese Schwierigkeit steht daher der Entwicklung von Schutzlackformulierungen für elektrische und/oder elektronische Baugruppen und/oder Bauelemente zurzeit noch entgegen. Unter Schutzlackformulierungen, die auf Basis von aus nachwachsenden Rohstoffen hergestellten Komponenten erhalten werden, werden also solche verstanden, die zumindest im Wesentlichen aus nicht synthetisierten oder synthetisch hergestellten Komponenten aufgebaut sind.

Der vorliegenden Erfindung liegt die Aufgabe zugrunde, eine Lösung zu schaffen, mit der ein Ressourcen schonender Klima- und Feuchteschutz für elektrische und/oder elektronische Bauelemente und/oder Baugruppen herstellbar ist.

Diese der Erfindung zugrunde liegende Aufgabe wird durch eine Schutzlackformulierung, die als Klima- und/oder Feuchteschutzüberzug auf elektrische und/oder elektronische Baugruppen und/oder Bauelemente aufbringbar ist, gelöst, die sich dadurch auszeichnet, dass sie zumindest im Wesentlichen auf zumindest einer aus mindestens einem nachwachsenden Rohstoff erhaltenen Komponente basiert und mindestens einen aus mindestens einem nachwachsenden Rohstoff erhaltenen Celluloseester oder mindestens einen aus mindestens einem nachwachsenden Rohstoff erhaltenen Cyclokautschuk umfasst. Die erfindungsgemäße Schutzlackformulierung ist somit aus einer oder mehreren Komponenten aufgebaut, die aus einem oder mehreren nachwachsenden Rohstoffen erhalten sind, wobei die Schutzlackformulierung weiterhin einen Celluloseester umfasst, der aus einem oder mehreren nachwachsenden Rohstoffen erhalten ist, oder wobei die Schutzlackformulierung einen Cyclokautschuk umfasst, der aus einem oder mehreren nachwachsenden Rohstoffen erhalten ist.

Die Erfinder haben überraschenderweise gefunden worden, dass von den nachwachsenden Rohstoffen insbesondere die Cellulosederivate, die durch Umsetzung von Cellulose mit einer oder mehreren organischen oder anorganischen Säuren entstehen, Potential für die Anwendung als Schutzlack für elektrische und/oder elektronische Baugruppen und/oder Bauelemente bieten.

Gegenstand der vorliegenden Erfindung ist daher eine Schutzlackformulierung, die als Klima- und/oder Feuchteschutzüberzug auf elektrische und/oder elektronische Baugruppen und/oder Bauelemente aufbringbar ist, die dadurch gekennzeichnet ist, dass sie zumindest im Wesentlichen auf einer mindestens einem nachwachsenden Rohstoff erhaltenen Komponente basiert und mindestens einen aus mindestens einem nachwachsenden Rohstoff erhaltenen Celluloseester umfasst.

Der durch die Verwendung einer solchen Formulierung erhaltene Schutzlack erfüllt sowohl die Vorgaben zu nachwachsenden Rohstoffen als auch die technischen Anforderungen bezüglich einer Schutzwirkung von elektronischen Baugruppen. Diese Anforderungen betreffen eine ausreichend niedrige Viskosität der Schutzlackformulierung sowie eine hohe Elastizität, die sich in einer hohen Temperaturwechselfestigkeit, z.B. in einem Temperaturschockbereich von -40 bis +125 °C, insbesondere von -40 bis + 85 °C, zeigt, einen hohen elektrischen Widerstand, der die elektrische Isolation auch unter Feuchtebeaufschlagung gewährleistet, und eine hohe chemische Widerstandsfähigkeit des daraus hergestellten Schutzlacks.

"Schutzlackformulierung" bedeutet im Zusammenhang dieser Erfindung eine Lackzusammensetzung im nicht ausgehärteten, d.h. in der Regel flüssigen Zustand, die beispielsweise als Lösung, Dispersion oder Suspension vorliegen kann. Im ausgehärteten Zustand bildet diese Formulierung einen Schutzlack aus. In der Regel werden die Schutzlackformulierungen der Erfindung in geeigneter und im Stand der Technik bekannter Art und Weise als Film auf einen Träger, beispielsweise die zu schützende Baugruppe oder das zu schützende Bauelement, aufgetragen und bilden nach dem Aushärten einen Schutzlacküberzug, eine Schutzlackbeschichtung oder einen Schutzlackfilm aus.

Die Ausdrücke "Schutzlack", "Isolierlack" und "Conformal Coating", die hierin austauschbar verwendet werden, bezeichnen einen Lack, üblicherweise eine Lackbeschichtung, einen Lacküberzug oder einen Lackfilm, der dem Klima- und/oder Feuchteschutz von elektrischen und/oder elektronischen Baugruppen und/oder Bauelementen dient.

Die Ausdrücke "Schutzlackfilm", "Schutzlacküberzug" und "Schutzlackbeschichtung" werden hierin austauschbar verwendet, um die auf einen Träger aufgebrachte und gegebenenfalls bereits ausgehärtete Lackschicht zu bezeichnen.

Die durch die Schutzlackformulierungen der Erfindung herstellbaren Beschichtungen auf Basis der Celluloseester bieten farblose, lichtechte und zum Teil schwer brennbare und wärmebeständige Schutzüberzüge. Typische Celluloseester sind Celluloseacetate, Celluloseacetobutyrate, Cellulosenitrate und Cellulosepropionate, weshalb die Erfindung in Ausgestaltung vorsieht, dass der mindestens eine Celluloseester ausgewählt ist aus Cellulosenitrat, Celluloseacetat, Celluloseacetobutyrat und Cellulosepropionat oder Kombinationen davon. Schutzlackformulierungen auf Basis von Celluloseestern weisen im Gegensatz zu natürlichen Ölen und Alkydharzen mit ihrer langsamen oxidativen Trocknung zum einen die geforderte schnelle Filmbildung auf und erfüllen zum anderen auch die Forderung nach einem einfachen späteren Rework der elektronischen Baugruppe durch das Ablösen mit einem Lösemittel.

Die durch die Formulierungen der Erfindung erhältlichen Beschichtungen auf Basis von Celluloseestern zeigen neben ihren guten lacktechnischen Eigenschaften wie Transparenz, schnelle Trocknung, reversible Löslichkeit und Haftung auch auf kritischen Untergründen überraschender Weise auch ausgezeichnete elektrische Isolationswerte, insbesondere auch bei Feuchtebeladung unter verschiedensten Temperatur-Feuchte-Konditionen.

Bei dem mindestens einen Celluloseester kann es sich um einen oder Mischungen von zwei, drei, vier oder mehr Celluloseestern handeln. Geeignete Celluloseester sind Ester von Cellulose mit organischen Säuren, wie beispielsweise Essigsäure, Propionsäure, Acetylbutansäure, oder mit anorganischen Säuren, wie beispielsweise Salpetersäure. Dementsprechend sind geeignete Celluloseester beispielsweise Celluloseacetat, Celluloseacetobutyrat, Cellulosenitrat und Cellulosepropionat, aber auch Celluloseacetophthalat. Ein bevorzugt verwendeter Celluloseester ist Cellulosenitrat, was die Erfindung ebenfalls vorsieht.

Im Fall der Verwendung von Celluloseestermischungen, können sich die verwendeten Celluloseester auch in ihrem Polymerisations- und/oder Substitutionsgrad unterscheiden. Dabei kann insbesondere die Auswahl von Celluloseestern mit unterschiedlichen mittleren Molekulargewichten sowie die Wahl des entsprechenden Massenverhältnisses dazu beitragen, die Eigenschaften der resultierenden Lackformulierung wie zum Beispiel die Viskosität und die Lackfilmeigenschaften wie Oberflächenhärte und Filmelastizität zu beeinflussen.

Die Menge des/der Celluloseester(s) in der Schutzlackformulierung kann variieren und liegt vorteilhafter Weise im Bereich von 4 - 40 Gew.-%, bevorzugter im Bereich von 4 - 20 Gew.-%, noch bevorzugter im Bereich von 4 - 10 Gew.-% bezogen auf das Gesamtgewicht der Formulierung, so dass die Erfindung vorsieht, dass der Masseanteil des mindestens einen Celluloseesters 4 - 40 Gew.-%, insbesondere 4 - 20 Gew.-%, bevorzugt 4 - 10 Gew.-%, bezogen auf das Gesamtgewicht der Schutzlackformulierung beträgt.

Schutzlackformulierungen können auch aus mehreren Celluloseestern bestehen. Die Erfindung zeichnet sich daher weiterhin dadurch aus, dass die Schutzlackformulierung mindestens zwei aus einem nachwachsenden Rohstoff erhaltene Celluloseester enthält, die sich in ihrem mittleren Molekulargewicht unterscheiden. Hierbei ist es möglich, dass die mindestens zwei Celluloseester aus jeweils dem gleichen nachwachsenden Rohstoff hergestellt und erhalten sind. Es ist aber auch durchaus möglich, dass die mindestens zwei Celluloseester aus jeweils unterschiedlichen nachwachsenden Rohstoffen hergestellt und erhalten sind.

Eine Schutzlackformulierung, die eine Mischung aus zwei Celluloseestern enthält, die sich in ihrem mittleren Molekulargewicht unterscheiden, kann in einer Ausführungsform der Erfindung beispielsweise 2,7 - 34,2 Gew.-%, vorzugsweise 3 - 20 Gew.-%, noch bevorzugter 4 -10 Gew.-% bezogen auf die Gesamtmasse der Lackformulierung eines ersten Celluloseesters und 0,4 - 8,3 Gew.-%, vorzugsweise 1 - 5 Gew.-%, noch bevorzugter 2 - 4 Gew.-% bezogen auf die Gesamtmasse der Lackformulierung eines zweiten Celluloseesters enthalten, wobei der erste Celluloseester ein niedrigeres mittleres Molekulargewicht als der zweite Celluloseester besitzt.

Allerdings sind Celluloseester als Alleinbindemittel in der Regel nicht geeignet. Üblich sind Kombinationen mit Alkydharzen, Weichharzen und/oder Weichmachern, wie z.B. epoxidiertem Sojaöl (ESBO).)

Die vorliegende Erfindung umfasst daher auch Schutzlackformulierungen auf Basis von Celluloseestern, die zusätzlich ein anderes Harz, beispielsweise ein Kombinationsharz, ein Alkydharz oder ein Weichharz sowie nach einem anderen Anspruch einen Weichmacher enthält.

Insbesondere lässt sich durch die Verwendung geeigneter Weichharze und/oder Weichmacher die gewünschte hohe Temperaturwechselfestigkeit der hergestellten Schutzlacke, z.B. in einem Temperaturschockbereich von -40 - + 125 °C, insbesondere von -40 - + 85 °C, erzielen.

Geeignete Weichmacher, die als Bestandteile der Schutzlackformulierungen dieser Erfindung verwendet werden können, sind insbesondere Weichmacher auf Nicht-Phthalsäure Basis, beispielsweise auf Glycidylbasis. Ein weiteres Beispiel für einen Weichmacher, der als Bestandteil der Schutzlackformulierungen der vorliegenden Erfindung verwendet werden kann, ist epoxidiertes Sojaöl (epoxydated soy bean oil, ESBO).

Die Weichmacher können in einem Masseanteil von 0,5 - 8 Gew. %, vorzugsweise von 1 - 4 Gew.-%, noch bevorzugter von 1,5 - 3 Gew.-% bezogen auf das Gesamtgewicht der Lackformulierung enthalten sein, was die Erfindung ebenfalls vorsieht.

Überraschenderweise hat sich herausgestellt, dass bezüglich der gestellten Anforderungen für eine Schutzlackformulierung auf Basis nachwachsender Rohstoffe für den Klima- und/oder Feuchteschutz von elektrischen und/oder elektronischen Baugruppen und/oder Bauelementen, auch aus natürlichem Latex gewonnene Naturkautschuke als Rohstoffquelle für die Schutzlackformulierungen für den Klima- und Feuchteschutz von elektrischen und/oder elektronischen Baugruppen und/oder Bauelementen geeignet sind. Mit für die Lackanwendung modifiziertem Cyclokautschuk kann ein Beschichtungsstoff hergestellt werden, der auf Grund seiner regelmäßigen und apolaren Molekülstruktur überraschend gute elektrische Isolationseigenschaften auch unter Feuchtebeladung aufweist.

Die obenstehende Aufgabe wird daher weiterhin auch gelöst durch eine Schutzlackformulierung, die als Klima- und/oder Feuchteschutzüberzug auf elektrische und/oder elektronische Baugruppen und/oder Bauelemente aufbringbar ist, und die sich dadurch auszeichnet, dass sie zumindest im Wesentlichen auf zumindest einer aus mindestens einem nachwachsenden Rohstoff erhaltenen Komponente basiert und mindestens einen aus mindestens einem nachwachsenden Rohstoff erhaltenen Cyclokautschuk umfasst.

"Cyclokautschuke" im Sinne der vorliegenden Erfindung, sind Produkte, die bei der Einwirkung von z.B. konzentrierter Schwefelsäure auf Naturkautschuke anfallen. Cyclokautschuke besitzen eine teilweise ringförmige Struktur und enthalten etwa 20-50% der Doppelbindungen des Ausgangsmaterials bevorzugt in den Ringstrukturen. Cyclokautschuke sind in aliphatischen, aromatischen und chlorierten Kohlenwasserstoffen löslich, wärmebeständiger als die Ausgangsmaterialien und werden von verdünnten Säuren, Alkalien, Salzlösungen und anderen korrodierenden Chemikalien nur wenig angegriffen.

Ebenso wie Schutzlackformulierungen auf Basis von Celluloseestern weisen auch Schutzlacke auf Basis von Cyclokautschuken im Gegensatz zu Alkydharzen und natürlichen Ölen mit ihrer langsamen oxidativen Trocknung zum einen die geforderte schnelle Filmbildung auf und erfüllen zum anderen auch die Forderung nach einem einfachen späteren Rework der elektronischen Baugruppe durch das Ablösen mit einem Lösemittel. Ferner erfüllen die Schutzlackformulierungen in vorteilhafter Weise auch die technische Anforderung einer ausreichend niedrigen Viskosität und die daraus hergestellten Schutzlacke die technischen Anforderungen einer hohen Temperaturwechselfestigkeit, einer geringen elektrischen Leitfähigkeit und einer hohen chemischen Widerstandsfähigkeit.

In Ausgestaltung sieht die Erfindung weiterhin vor, dass der Masseanteil des mindestens einen Cyclokautschuks 7 - 38 Gew.-%, insbesondere 15 - 35 Gew.-%, bezogen auf das Gesamtgewicht der Schutzlackformulierung beträgt.

Der Masseanteil des Cyclokautschuks oder einer entsprechenden Mischung von Cyclokautschuken in einer Schutzlackformulierung der vorliegenden Erfindung beträgt in der Regel zwischen etwa 7 und 38 Gew-%, vorzugsweise zwischen 15 und 35 Gew.-%, besonders bevorzugt zwischen 20 und 30 Gew.-% und am bevorzugtesten zwischen 24 und 28 Gew.-% bezogen auf die Gesamtmasse der Lackformulierung.

Die erfindungsgemäß in einer Schutzlackformulierung verwendeten Cyclokautschuke können mit entsprechend den Anforderungen der elektrischen Isolationswirkung ausgewählten Weichharzen und/oder Weichmachern kombiniert werden. Die so erhaltenen erfindungsgemäßen Schutzlacke zeichnen sich durch besonders gute Isoliereigenschaften aus.

Die Weichmacher können in einem Masseanteil von 0,3 - 25 Gew. %, vorzugsweise von 5 - 20 Gew.-%, noch bevorzugter von 10 - 15 Gew.-% bezogen auf das Gesamtgewicht der Lackformulierung enthalten sein.

Im Zusammenhang mit Schutzlackformulierungen auf Cyclokautschuk-Basis geeignete Weichmacher sind dieselben, die im Zusammenhang mit Schutzlackformulierungen auf Celluloseester-Basis erwähnt werden, d.h. insbesondere Weichmacher auf Nicht-Phthalsäure-Basis, vorzugsweise auf Gylcidylbasis. Ein geeigneter Weichmacher kann aber z.B. auch epoxidiertes Sojaöl (ESBO) sein.

Analog zu den Schutzlackformulierungen auf Celluloseesterbasis, lässt sich auch bei Schutzlackformulierungen auf Basis von Cyclokautschuken durch die Verwendung geeigneter Weichharze und/oder Weichmacher die gewünschte Elastizität und die damit verbundene hohe Temperaturwechselfestigkeit der dadurch hergestellten Schutzlacke erzielen.

Neben Weichmachern können die erfindungsgemäßen Schutzlackformulierung auf Celluloseesterbasis oder auf Cyclokautschukbasis auch weitere Hilfs-, Träger- und Zusatzstoffe enthalten, wie beispielsweise Lösemittel, Benetzungsmittel, Entschäumer, Verlaufsadditive (Fließmittel), Tenside und/oder Farbstoffe oder Kombinationen davon.

Als Lösemittel für die Schutzlackformulierungen auf Celluloseester- oder Cyclokautschukbasis eignen sich insbesondere organische Lösemittel wie Kohlenwasserstoffe, Alkohole, Ether oder Ester oder Mischungen davon. Vorzugsweise werden Ester oder Mischungen verschiedener Ester verwendet. Ein besonders bevorzugtes Lösemittel ist Butylacetat oder eine Mischung von Butylacetat mit anderen organischen Estern. Ein anderes geeignetes Lösemittel ist PMA (Propylenglykolmonomethyletheracetat/Methoxypropylacetat).

Die verwendeten Entschäumer sind vorzugsweise silikonfrei und umfassen beispielsweise kommerziell erhältliche Entschäumer auf Acrylat- oder Methacrylatbasis.

Die Verlaufsadditive, die im Zusammenhang mit den Schutzlackformulierungen der Erfindungen eingesetzt werden können, können ebenfalls auf Acrylaten basieren und gegebenenfalls zusätzlich auch entschäumende Eigenschaften aufweisen. Die Verlaufsadditive dienen dazu die Fließeigenschaften und die Benetzungsfähigkeit der Schutzlackformulierungen zu verbessern.

Tenside können als Bestandteil der Schutzlackformulierungen verwendet werden, um die Oberflächeneigenschaften des Lackfilms in vorteilhafte Art und Weise zu beeinflussen. Daher sind Schutzlacke mit geeigneten Oberflächenmodifizierungsmitteln, d.h. Tensiden, ein weiterer Gegenstand der vorliegenden Erfindung. Die aus solchen Formulierungen hergestellten Schutzlacke, weisen eine überraschend gute elektrische Isolations- und Schutzwirkung auf, wobei durch die stark herabgesetzte Grenzflächenenergie die Benetzungsfähigkeit mit Feuchtigkeit und somit auch die Verschmutzungsneigung reduziert wird. Das führt zu verbesserten Langzeitbeständigkeiten bezüglich der Isolationseigenschaft des Lackfilmes. Im Zusammenhang mit den Schutzlacken dieser Erfindung geeignete Tenside, sind silikonfreie Tenside, insbesondere silikonfreie Fluortenside.

Die aus den beschriebenen Formulierungen erhaltenen Schutzlacke für die Elektronik kommen auch in räumliche Nähe mit Schaltkontakten. Von Schaltkontakten ist bekannt, dass es unter ungünstigen Bedingungen mit flüchtigen Silikonen zu so genannten Silikonkontaminationen und zu Ausfällen kommen kann. Die auf der Schaltfläche rekondensierten Silikone bauen sich bei Schaltvorgängen mit einem kleinen Lichtbogen zu Siliziumdioxid ab, welches bei ausreichender Belegung dann zu isolierenden Schaltflächen führen kann. Aus diesem Grund sind die in den Schutzlackformulierungen der vorliegenden Erfindung verwendeten Bestandteile, insbesondere die gegebenenfalls verwendeten Entschäumer, Verlaufsadditive und/oder Tenside, silikonfrei.

Die verwendeten Farbstoffe sind vorzugsweise Fluoreszenzfarbstoffe und dienen dazu die Vollständigkeit der Benetzung der elektrischen und/oder elektronischen Baugruppen und/oder Bauelemente mit dem Schutzlack überprüfen zu können.

Eine geeignete Formulierung auf Basis von Celluloseestern umfasst:

| | |
|---|---|
| 30 - 50 | Teile einer Celluloseesterlösung 1 |
| 5 - 10 | Teile einer Celluloseesterlösung 2 |
| 0,5 - 5 | Teile eines gelierenden Weichmachers/Weichharzes |
| 0,1 - 1,0 | Teile eines Fluoreszenzfarbstoffes |
| 0,1 - 1,0 | Teile eines Entschäumers |
| 64,4 - 32 | Teile Lösemittel oder Lösemittelmischung |

Eine alternative Formulierung auf Basis von Celluloseester umfasst:

| | |
|---|---|
| 20 - 60 | Teile einer Celluloseesterlösung 3 |
| 0,5 - 5 | Teile eines gelierenden Weichmachers/Weichharzes |
| 0,1 - 1,0 | Teile eines Fluoreszenzfarbstoffes |
| 0,1 - 1,0 | Teile eines Entschäumers |
| 64,4 - 32 | Teile Lösesmittel oder Lösemittelmischung |

Dabei beinhaltet Celluloseesterlösung 1 10 - 60 Teile Celluloseester A und 90 - 40 Teile Butylacetat oder eine entsprechende Lösemittelmischung, Celluloseesterlösung 2 beinhaltet 10 - 60 Teile Celluloseester B und 90 - 40 Teile Butylacetat oder eine entsprechende Lösemittelmischung und Celluloseesterlösung 3 beinhaltet10 - 60 Teile Celluloseester und 90 - 40 Teile Butylacetat oder eine entsprechender Lösemittelmischung.

Neben Butylacetat sind andere Ester oder Mischungen von Estern ebenfalls als Lösemittel geeignet. Ein anderes geeignetes Lösemittel ist beispielsweise PMA (Propylenglykolmonomethyletheracetat).

Der Celluloseester wird vorzugsweise aus Cellulosenitrat, Celluloseacetobutyrat und Cellulosepropionat ausgewählt. Celluloseester A ist vorzugsweise ein Cellulosenitrat, während Celluloseester B vorzugsweise ein Celluloseacetobutyrat oder ein Cellulosepropionat ist. Die beiden Celluloseesterlösungen 1 und 2 unterscheiden sich in ihrem mittleren Molekulargewicht. Vorzugsweise besitzt Celluloseesterlösung 1 ein niedrigeres mittleres Molekulargewicht als Celluloseesterlösung 2. Wie oben erwähnt, sind die verwendete Weichmacher/Weichharze vorzugsweise solche auf Nicht-Phthalsäurebasis, bevorzugter auf Glycidyl-Basis. In vorteilhafter Weise kann als Weichmacher aus epoxidiertes Sojaöl (ESBO) verwendet werden.

Gegebenenfalls können die oben beispielhaft genannten Formulierungen, zusätzlich noch 0,1 - 3 Teile eines oberflächenaktiven Tensids enthalten. Dieses Tensid ist vorzugsweise ein silikonfreies Tensid, insbesondere ein silikonfreies Fluortensid. Das Tensid kann dazu dienen die Oberfläche des erhaltenen Lackfilms zu modifizieren, indem beispielsweise die Hydrophobizität erhöht wird. Das verringert die Benetzungsfähigkeit mit Wasser und damit auch die Neigung zu verschmutzen, wodurch wiederum die Langzeitbeständigkeit des Lacks erhöht wird.

Eine geeignete Formulierung auf Basis von Cyclokautschuk enthält beispielsweise:

| | |
|---|---|
| 30 - 80 | Teile einer Cyclokautschuklösung |
| 0,5 - 25 | Teile eines gelierenden Weichmachers/Weichharzes |
| 0,1 - 1,0 | Teile eines Fluoreszenzfarbstoffes |
| 0,1 - 1,0 | Teile eines Entschäumers |
| 0,1 - 1,0 | Teile eines Oberflächenadditivs |
| 45 - 65 | Teile Lösemittel/Lösemittelgemisch |

Die Cyclokautschuklösung besteht dabei aus 30 - 60 Teilen eines Cyclokautschuks oder einer Cyclokautschukmischung, die in 70 - 40 Teilen eines Lösemittels oder Lösemittelgemisches (z.B. Butylacetat oder Butylacetat enthaltende Mischungen) gelöst sind. Neben Butylacetat sind andere Ester oder Mischungen von Estern ebenfalls als Lösemittel geeignet.

Die verwendeten Weichmacher/Weichharze sind vorzugsweise solche auf Nicht-Phthalsäurebasis, bevorzugter auf Glycidyl-Basis. Alternativ kann in einer bevorzugten Ausführungsform der Erfindung der verwendete Weichmacher auch epoxidiertes Sojaöl (ESBO) sein.

Die bei der Schutzlackformulierung auf Basis von Cyclokautschuk verwendeten Entschäumer, Verlaufsadditive und Tenside entsprechen denen, die vorstehend im Zusammenhang mit Schutzlackformulierungen auf Celluloseesterbasis genannt werden. Diese Bestandteile sind ebenfalls vorzugsweise silikonfrei, um Silikonkontamination der Schaltkontakte einer elektrischen und/oder elektronischen Baugruppe und/oder eines elektrischen und/oder elektronischen Bauelements zu vermeiden.

Bei den verwendeten Farbstoffen handelt es sich wie auch bei der Schutzlackformulierung auf Celluloseesterbasis beispielsweise um Fluoreszenzfarbstoffe, die eine Überprüfung der Vollständigkeit der Benetzung von elektrischen und/oder elektronischen Baugruppen und/oder Bauelementen mit der erfindungsgemäßen Lackformulierung erlauben.

Um die Oberflächen eines mittels einer solchen Lackformulierung erhaltenen Lackfilms in geeigneter Art und Weise zu modifizieren, kann die oben beispielhaft genannte Formulierung auf Cyclokautschukbasis analog zu der Schutzlackformulierung auf Celluloseesterbasis, zusätzlich 0,1 - 3 Teile eines oberflächenaktiven Tensids enthalten. Dieses Tensid ist ebenfalls vorzugsweise ein silikonfreies Tensid, insbesondere ein silikonfreies Fluortensid. Die Erhöhung der Hydrophobizität durch die Verwendung eines solchen Tensids verringert die Benetzungsfähigkeit mit Wasser und damit auch die Neigung zu verschmutzen, wodurch wiederum die Langzeitbeständigkeit des Lacks erhöht wird.

Die oben stehende Aufgabe wird weiterhin auch gelöst durch die Verwendung einer Schutzlackformulierung nach einem der Ansprüche 1-26 auf Celluloseester- bzw. Cyclokautschukbasis zur Ausbildung eines Überzugs oder einer Beschichtung auf einem/einer oder mehreren elektrischen und/oder elektronischen Bauelement(en) oder Baugruppe(n). Der nach dem Aushärten des flüssigen Films erhaltene Schutzlacküberzug dient dazu das Bauelement/ die Baugruppe vor nachteiligen Umwelteinflüssen, insbesondere Feuchtigkeit, zu schützen. Der so erhaltene Schutzlacküberzug erfüllt in vorteilhafter Art und Weise die technischen Anforderungen hinsichtlich einer hohen Elastizität, einer hohen elektrischen Isolationsfähigkeit und einer hohen chemischen Widerstandsfähigkeit.

Die Beschichtung des Bauelements/der Baugruppe mit der Schutzlackformulierung kann mittels Verfahren erfolgen, die im Stand der Technik bekannt sind, und schließt unter anderem Dip coating, Film coating, Spin coating und Spray coating ein. Damit die Schutzlackformulierung für ein solches Aufbringungsverfahren geeignet ist, muss sie eine ausreichend niedrige Viskosität besitzen.

Die Erfindung löst die oben stehende Aufgabe, weiterhin auch durch eine Feuchteschutzbeschichtung eines elektrischen oder elektronischen Bauelements oder einer elektrischen oder elektronischen Baugruppe, die sich dadurch auszeichnet, dass sie zumindest im Wesentlichen aus einer Schutzlackformulierung gebildet ist, die auf mindestens einer aus mindestens einem nachwachsenden Rohstoff erhaltenen Komponente basiert und mindestens einen aus mindestens einem nachwachsenden Rohstoff erhaltenen Celluloseester oder mindestens einen aus mindestens einem nachwachsenden Rohstoff erhaltenen Cyclokautschuk umfasst.

Hierbei lassen sich besonders vorteilhafte und zweckmäßige Feuchteschutzbeschichtungen dadurch erhalten, dass sie eine Schutzlackformulierung nach einem der Ansprüche 1-26 umfassen, was die Erfindung in Weiterbildung vorsieht.

Schließlich bezieht sich die Erfindung zur Lösung der oben stehenden Aufgabe auch noch auf ein elektrisches und/oder elektronisches Bauelement und/oder eine elektrische oder elektronische Baugruppe, das/die ganz oder teilweise einen Klima- und/oder Feuchteschutzüberzug aus einem Schutzlack aufweist, wobei der Schutzlack auf einer Schutzlackformulierung basiert, die zumindest im Wesentlichen auf zumindest einer aus mindestens einem nachwachsenden Rohstoff erhaltenen Komponente basiert und mindestens einen aus mindestens einem nachwachsenden Rohstoff erhaltenen Celluloseester oder Cyclokautschuk umfasst.

Die folgenden Ausführungsbeispiele für Schutzlackformulierungen gemäß der Erfindung dienen dazu die Erfindung weiter zu veranschaulichen. Es sind jeweils die Bestandteile und Kenndaten der Schutzlackformulierung und die elektrischen und klimatischen Kenndaten des nach Trocknung der Formulierung erhaltenen Schutzlackes angegeben.

### Beispiel 1:

### Schutzlackformulierung auf Celluloseesterbasis

| **Bestandteil** | **Gew.-%*** |
|---|---|
| Nitrocellulose Typ 9 E (in Isopropanol angefeuchtet) | 5,55 |
| Nitrocellulose Typ 33 E (in Ethanol angefeuchtet) | 2,52 |
| Sojaöl, epoxidiert | 2,00 |
| Entschäumer (silikonfrei) | 0,40 |
| Verlaufsadditiv (silikonfrei) | 1,12 |
| Fluortensid | 0,40 |
| Fluoreszenzfarbstoff | 0,20 |
| PMA | 1,38 |
| Butylacetat | 86,43 |
| | 100,00 |

| | |
|---|---|
| * bezogen auf die Masse der Gesamtlackformulierung | |

### Kenndaten:

| | |
|---|---|
| Viskosität DIN 4 | 55 Sekunden |
| Viskosität ISO 5 | 75 Sekunden |
| Dichte bei 20°C | 0,91 g/cm³ |
| Flammpunkt | 25°C |

### Elektrische Kenndaten:

| | |
|---|---|
| Durchgangswiderstand | 2,7 *10¹⁵ Ohm*cm |
| Oberflächenwiderstand | 2,0 *10¹⁴ Ohm |
| Durchschlagfestigkeit | 156 KV/mm |
| Kriechstromfestigkeit | 375 V auf 250 V (wird wiederholt) |

### Klimatische Kenndaten:

| | | |
|---|---|---|
| 85/85 Test | 65°C | ca. 5 *10⁹ Ohm |
| | 85°C | ca. 5 *10⁸ Ohm |
| Schwitzwassertest | | ca. 1*10¹² Ohm |
| Temperaturschocktest | | bestanden (150 Zyklen -40°C,+85°C, Wechsel <10Sekunden) |

### Beispiel 2:

### Schutzlackformulierung auf Cyclokautschukbasis

| **Bestandteil** | **Gew.-%*** |
|---|---|
| Cyclokautschuk (nativ) | 26,90 |
| Sojaöl, epoxidiert | 13,65 |
| Entschäumer (silikonfrei) | 0,20 |
| Verlaufsadditiv | 0,20 |
| Fluortensid | 0,40 |
| Fluoreszenzfarbstoff | 0,30 |
| Butylacetat | 58,35 |
| | 100,00 |

| | |
|---|---|
| * bezogen auf die Masse der Gesamtlackformulierung | |

### Kenndaten:

| | |
|---|---|
| Viskosität DIN 4 | 23 Sekunden |
| Dichte bei 20°C | 0,93 g/cm³ |
| Flammpunkt | 27°C |

### Elektrische Kenndaten:

| | |
|---|---|
| Durchgangswiderstand | 1,2 *10¹⁴ Ohm*cm |
| Oberflächenwiderstand | 2,0 *10¹⁴ Ohm |
| Durchschlagfestigkeit | 100 KV/mm |
| Kriechstromfestigkeit | 600 V auf 250 V |

### Klimatische Kenndaten:

| | | |
|---|---|---|
| 85/85 Test | 65°C | ca. 5 *10¹⁰ Ohm |
| | 85°C | ca. 1 *10¹⁰ Ohm |
| Schwitzwassertest | | ca. 1*10⁹ Ohm |
| Temperaturschocktest | | bestanden (150 Zyklen -40°C,+85°C, Wechsel <10 Sekunden) |

## Patentansprüche

1. Schutzlackformulierung, die als Klima- und/oder Feuchteschutzüberzug auf elektrische und/oder elektronische Baugruppen oder Bauelemente aufbringbar ist,
**dadurch gekennzeichnet,**
**dass** die Schutzlackformulierung zumindest im Wesentlichen auf zumindest einer aus mindestens einem nachwachsenden Rohstoff erhaltenen Komponente basiert und mindestens einen aus mindestens einem nachwachsenden Rohstoff erhaltenen Celluloseester umfasst.

2. Schutzlackformulierung nach Anspruch 1, **dadurch gekennzeichnet, dass** der mindestens eine Celluloseester ausgewählt ist aus Cellulosenitrat, Celluloseacetat, Celluloseacetobutyrat und Cellulosepropionat oder Kombinationen davon.

3. Schutzlackformulierung nach Anspruch 1 oder 2, **dadurch gekennzeichnet, dass** der Celluloseester Cellulosenitrat ist.

4. Schutzlackformulierung nach einem der Ansprüche 1 bis 3, **dadurch gekennzeichnet, dass** der Masseanteil des mindestens einen Celluloseesters 4 - 40 Gew.-%, insbesondere 4 - 20 Gew.-%, bevorzugt 4 - 10 Gew.-%, bezogen auf das Gesamtgewicht der Schutzlackformulierung beträgt.

5. Schutzlackformulierung nach einem der Ansprüche 1 bis 4, **dadurch gekennzeichnet, dass** die Schutzlackformulierung mindestens zwei aus einem nachwachsenden Rohstoff erhaltene Celluloseester enthält, die sich in ihrem mittleren Molekulargewicht unterscheiden.

6. Schutzlackformulierung nach einem der Ansprüche 1 bis 5, **dadurch gekennzeichnet, dass** die Schutzlackformulierung zusätzlich ein Kombinationsharz, ein Alkydharz oder ein Weichharz enthält.

7. Schutzlackformulierung nach einem der Ansprüche 1 bis 6, **dadurch gekennzeichnet, dass** die Schutzlackformulierung zusätzlich einen Weichmacher enthält.

8. Schutzlackformulierung nach Anspruch 7, **dadurch gekennzeichnet, dass** der Masseanteil des Weichmachers 0,5 - 8 Gew. %, insbesondere 1 - 4 Gew. %, bevorzugt 1,5 - 3 Gew.-%, bezogen auf das Gesamtgewicht der Lackformulierung beträgt.

9. Schutzlackformulierung, die als Klima- und/oder Feuchteschutzüberzug auf elektrische und/oder elektronische Baugruppen oder Bauelemente aufbringbar ist,
**dadurch gekennzeichnet,**
**dass** die Schutzlackformulierung zumindest im Wesentlichen auf zumindest einer aus einem nachwachsenden Rohstoff erhaltenen Komponente basiert und mindestens einen aus mindestens einem nachwachsenden Rohstoff erhaltenen Cyclokautschuk umfasst.

10. Schutzlackformulierung nach Anspruch 9, **dadurch gekennzeichnet, dass** der Masseanteil des mindestens einen Cyclokautschuks 7 - 38 Gew.-%, insbesondere 15 - 35 Gew.-% bezogen auf das Gesamtgewicht der Schutzlackformulierung beträgt.

11. Schutzlackformulierung nach einem der Ansprüche 9 oder 10, **dadurch gekennzeichnet, dass** die Schutzlackformulierung zusätzlich einen Weichmacher enthält.

12. Schutzlackformulierung nach Anspruch 11, **dadurch gekennzeichnet, dass** der Masseanteil des Weichmacher 0,3 - 25 Gew.-%, insbesondere 5 - 20 Gew.-%, bevorzugt 10 - 15 Gew.-%, bezogen auf das Gesamtgewicht der Schutzlackformulierung beträgt.

13. Schutzlackformulierung nach einem der Ansprüche 7, 8, 11 oder 12, **dadurch gekennzeichnet, dass** der Weichmacher ein Weichmacher auf Nicht-Phthalsäurebasis ist.

14. Schutzlackformulierung nach Anspruch 13, **dadurch gekennzeichnet, dass** der Weichmacher ein Weichmacher auf Glycidylbasis ist.

15. Schutzlackformulierung nach Anspruch 13, **dadurch gekennzeichnet, dass** der Weichmacher epoxidiertes Sojaöl (ESBO) ist.

16. Schutzlackformulierung nach einem der Ansprüche 1 bis 15, **dadurch gekennzeichnet, dass** die die Schutzlackformulierung mindestens einen zusätzlichen Bestandteil ausgewählt aus der Gruppe der Lösemittel, Entschäumer, Verlaufsadditiv, Tenside und Farbstoffe oder Kombinationen davon enthält.

17. Schutzlackformulierung nach Anspruch 16, **dadurch gekennzeichnet, dass** das Lösemittel ein organisches Lösemittel ausgewählt aus der Gruppe der Kohlenwasserstoffe, Ester, Ether, Alkohole oder Mischungen davon ist.

18. Schutzlackformulierung nach Anspruch 17, **dadurch gekennzeichnet, dass** das Lösemittel ein Ester oder eine Estermischung ist.

19. Schutzlackformulierung nach Anspruch 18, **dadurch gekennzeichnet, dass** der Ester oder die Estermischung Butylacetat oder eine Butylacetat enthaltende Estermischung ist.

20. Schutzlackformulierung nach einem der Ansprüche 16-19, **dadurch gekennzeichnet, dass** der Entschäumer ein silikonfreier Entschäumer ist.

21. Schutzlackformulierung nach Anspruch 20, **dadurch gekennzeichnet, dass** der silikonfreie Entschäumer ein silikonfreier Acrylatentschäumer ist.

22. Schutzlackformulierung nach einem der Ansprüche 16-21, **dadurch gekennzeichnet, dass** das Verlaufsadditiv ein silikonfreies Verlaufsadditiv ist.

23. Schutzlackformulierung nach Anspruch 22, **dadurch gekennzeichnet, dass** das silikonfreie Verlaufsadditiv ein silikonfreies Verlaufsadditiv auf Acrylatbasis ist.

24. Schutzlackformulierung nach einem der Ansprüche 16-23, **dadurch gekennzeichnet, dass** das Tensid ein silikonfreies Tensid ist.

25. Schutzlackformulierung nach Anspruch 24, **dadurch gekennzeichnet, dass** das silikonfreie Tensid ein silikonfreies Fluortensid ist.

26. Schutzlackformulierung nach einem der Ansprüche 16-25, **dadurch gekennzeichnet, dass** der Farbstoff ein Fluoreszenzfarbstoff ist.

27. Verwendung einer Schutzlackformulierung nach einem der Ansprüche 1-26 zur Ausbildung eines Überzugs oder einer Beschichtung auf einem/einer oder mehreren elektrischen und/oder elektronischen Bauelement(en) oder Baugruppe(n).

28. Feuchteschutzbeschichtung eines elektrischen oder elektronischen Bauelements oder einer elektrischen oder elektronischen Baugruppe, **dadurch gekennzeichnet, dass** sie zumindest im Wesentlichen aus einer Schutzlackformulierung gebildet ist, die auf mindestens einer aus mindestens einem nachwachsenden Rohstoff erhaltenen Komponente basiert und mindestens einen aus mindestens einem nachwachsenden Rohstoff erhaltenen Celluloseester oder mindestens einen aus mindestens einem nachwachsenden Rohstoff erhaltenen Cyclokautschuk umfasst.

29. Feuchteschutzbeschichtung nach Anspruch 28, **dadurch gekennzeichnet, dass** sie eine Schutzlackformulierung nach einem der Ansprüche 1-26 umfasst.

30. Elektrische(s) und/oder elektronische(s) Baugruppe oder Bauelement, die/das ganz oder teilweise einen Klima- und/oder Feuchteschutzüberzug aus einem Schutzlack aufweist,
**dadurch gekennzeichnet,**
**dass** der Schutzlack auf einer Schutzlackformulierung basiert, die zumindest im Wesentlichen auf zumindest einer aus mindestens einem nachwachsenden Rohstoff erhaltenen Komponente basiert und mindestens einen aus mindestens einem nachwachsenden Rohstoff erhaltenen Celluloseester umfasst.

31. Elektrische(s) und/oder elektronische (s) Baugruppe oder Bauelement, die/das ganz oder teilweise einen Klima- und/oder Feuchteschutzüberzug aus einem Schutzlack aufweist,
**dadurch gekennzeichnet,**
**dass** der Schutzlack auf einer Schutzlackformulierung basiert, die zumindest im Wesentlichen auf zumindest einer aus mindestens einem nachwachsenden Rohstoff erhaltenen Komponente basiert und mindestens einen aus mindestens einem nachwachsenden Rohstoff erhaltenen Cyclokautschuk umfasst.

32. Elektrische(s) und/oder elektronische(s) Baugruppe oder Bauelement nach Anspruch 30 oder 31,
**dadurch gekennzeichnet,**
**dass** der Schutzlack aus einer Schutzlackformulierung nach einem der Ansprüche 1-26 erhältlich ist.
